Europäisches Patentamt

European Patent Office

Office européen des brevets

(11) Publication number: **0 432 493 A2**

# EUROPEAN PATENT APPLICATION

(21) Application number: 90121777.8

(22) Date of filing: **14.11.90**

(51) Int. Cl.⁵ **G03F 7/07**, G03C 8/28, H05K 3/10

(30) Priority: **16.11.89 US 437937**

(43) Date of publication of application:
**19.06.91 Bulletin 91/25**

(84) Designated Contracting States:
**DE DK FR GB IT NL**

(71) Applicant: **E.I. DU PONT DE NEMOURS AND COMPANY**
**1007 Market Street**
**Wilmington Delaware 19898(US)**

(72) Inventor: **Cairncross, Allan**
**24 Cinnamon Drive, RD 3**
**Hockessin, Delaware 19707(US)**
Inventor: **Thayer, Chester Arthur II**
**123 Parrish Lane**
**Wilmington, Delaware 19810(US)**

(74) Representative: **von Kreisler, Alek,**
**Dipl.-Chem. et al**
**Patentanwälte Von Kreisler-Selting-Werner,**
**Deichmannhaus am Hauptbahnhof**
**W-5000 Köln 1(DE)**

(54) Electronic circuitry utilizing silver diffusion transfer imaging.

(57) An improved silver diffusion transfer process Is disclosed which is useful in formation of adherent electrical circuitry.

EP 0 432 493 A2

# ELECTRONIC CIRCUITRY UTILIZING SILVER DIFFUSION TRANSFER IMAGING

## FIELD OF THE INVENTION

The following invention relates to a process for making conducting metal patterns on an insulating substrate useful in the electronic industry and to the articles made using such a process. More particularly, it relates to a silver diffusion transfer imaging process for making conducting metal patterns and the articles made using that process.

## BACKGROUND OF THE INVENTION

Printed circuits used in the electronics industry consist of thin metal circuit traces attached to a dielectric substrate in single or multilayer structures. The circuit traces are frequently made starting with a laminate of copper and dielectric material and applying a photoresist. In a subtractive process the copper layer is covered with a photoresist which is then exposed and developed leaving the copper covered only in the circuit pattern areas. The copper not covered is then removed by chemical etching. Removal of the photoresist leaves a copper circuit pattern on the dielectric substrate.

A semi-additive process begins with a laminate which has a copper layer of only 0.1 mils thick or less. A photoresist is applied, exposed and developed. Then the circuit pattern is electroplated to the desired thickness in the areas which are not covered by the photoresist. After the photoresist is stripped, the copper is back etched to leave the circuit traces electrically isolated from each other. Both photoresist-based processes require many processing steps. Further, as higher circuit density elements are needed it is necessary to have higher resolution than is possible with most thick film photoresist systems.

Silver halide photographic systems have very high resolution and under special conditions are known to produce electrically conducting circuit patterns. When a standard silver halide emulsion layer is exposed to light and developed normally a black metallic silver image is produced that is generally not conductive. It is possible to achieve a conducting silver image as disclosed in U.S. Patent Nos. 2,854,386, 3,424,581, 3,551,149, 3,647,456 and 4,868,081.

A conducting silver image is most easily obtained using diffusion transfer development techniques. With diffusion transfer development, an exposed silver halide emulsion layer is developed in contact with a receptor layer which contains diffusion transfer nuclei. The developer includes a compound which complexes the undeveloped silver halide allowing it to diffuse to the receptor layer where the diffusion transfer nuclei catalyse the formation of metallic silver. In many cases this diffusion transfer image in the receptor layer has silver concentrated near the interface between the emulsion and the receiver and its surface is electrically conductive.

In conventional diffusion transfer films the diffusion transfer nuclei are applied to the substrate in a binder, e.g., gelatin or a synthetic polymer along with other additives such as colloidal silica, in order to obtain adequate separation of nuclei, enhance image covering power, and adhere the image to its support during removal of the emulsion layer. However, these binders can adversely affect the electrical properties and high temperature stability of the resulting circuits. Silver diffusion transfer systems using binderless diffusion transfer nuclei have been disclosed in U.S. Patent Nos. 3,600,185 and 3,822,127.

However, none of the above references has been able to achieve the stringent balance of properties necessary for the production of a commercial circuit such as used by the electronics industry today. The choice of final circuit substrate and processing steps must produce a circuit with good electrical properties, good mechanical properties, good resistance to chemicals and moisture and good thermal stability, particularly for circuits which are to be soldered.

For many applications the thin diffusion transfer silver circuits have too much resistance and need to be plated up with metal to become more conductive. This can be accomplished by electroplating or electroless plating techniques. It is known that silver is a poor catalyst for electroless plating and often is activated by treatment with palladium ion prior to plating as disclosed in U.S. Patents 3,600,185 and 3,822,127. However, these treatments can result in unwanted plating of background areas.

In addition, it is known that silver metal can migrate and form dendrites and that these dendrites can result in circuit failure.

It is therefore an object of this invention to provide an improved process for the formation of conducting silver circuit patterns which satisfy all of the criteria for commercial circuits as described above. It is further an object of this invention to provide silver circuit patterns which can be electroplated and or electrolessly plated up and which resist the formation of silver dendrites.

## SUMMARY OF THE INVENTION

This invention relates to a process for the formation of adherent electrically conductive metal patterns on an insulating substrate which comprises the steps:

(a) applying a hydrophilic treatment to the insulating substrate to impart hydrophilicity to a surface portion of the substrate

(b) applying diffusion transfer nuclei in the absence of a binder to a hydrophilic portion of the insulating substrate

(c) applying a silver halide containing photosensitive material either as a layer on the insulating substrate overlying the nuclei or as a layer on a second substrate

(d) exposing to actinic radiation a portion of the photosensitive material layer,

(e) applying developer solution to the layer exposed in step (d)

(f) forming a pattern of silver metal on the insulating substrate by silver diffusion transfer wherein a surface portion of the layer contacts the diffusion transfer nuclei,

(g) removing the layer that originally contained the silver halide while leaving the pattern of silver formed in step (f) on the surface of the insulating substrate.

In a second aspect, this invention relates to a process for the formation of adherent electrically conductive metal patterns on an insulating substrate which comprises the steps:

(a) applying a hydrophilic treatment to the insulating substrate to impart hydrophilicity to a surface portion of the substrate,

(b) applying diffusion transfer nuclei in the absence of a binder to a hydrophilic portion of the insulating substrate,

(c) applying a silver halide containing photosensitive material either as a layer on the insulating substrate overlying the diffusion transfer nuclei or as a layer on a second substrate,

(d) exposing to actinic radiation a portion of the photosensitive material layer,

(e) applying developer solution to the layer exposed in step (d),

(f) forming a pattern of silver as a coating on the substrate by silver diffusion transfer wherein a surface portion of the layer contacts the diffusion transfer nuclei,

(g) removing the layer that originally contained the silver halide material while leaving the pattern of silver formed in step (f) on the surface of the insulating substrate,

(h) treating the developed pattern of silver with an acidic solution having a pH of from about 0 to 5, wherein step (h) is carried out simultaneously with step (g) or immediately after step (g).

(i) treating the silver pattern with an aqueous solution containing metal ions selected from the group consisting essentially of Pd(II), Pt(IV), Rh(III) and mixtures thereof, said solution having a pH no greater than 4.0 and also having a halide ion concentration no less than 0.03 M, and

(j) electrolessly plating the treated silver pattern from step (g) with at least one conductive metal.

In a third aspect, this invention relates to articles which are useful for the formation of electronic devices such as printed circuit boards comprising an insulating substrate and a silver layer bonded thereto wherein the silver pattern layer was formed by the diffusion transfer processes described above.

## DETAILED DESCRIPTION OF THE INVENTION

The present invention relates to a process for making adherent electrically conductive circuitry on an insulating substrate. The support material and the processing steps must be chosen so as to produce a final circuit with the desired properties. This is accomplished by forming a silver metal circuit pattern by silver diffusion transfer imaging on a suitable substrate. The silver image then may be plated over with other conductive metals as desired.

The choice of circuit substrate and processing steps must produce a circuit which meets certain test criteria. Examples of these criteria, test methods and specifications are given in ANSI IPC-FC-231B, ANSI/IPC-FC-241B, and ANSI/IPC-TM-650 published by the Institute for Interconnecting and Packaging Electronics Circuits, Lincolnwood, IL. In general an electronic substrate should have good electrical properties such as a dielectric constant less than 4 and a dissipation factor at 1 MHz better than 0.05. It should also have good mechanical properties such as a dimensional stability better than 0.20% for flexible substrates (a factor of 10 better for rigid substrates) and tensile strength greater than 20,000 lb/sq. in. A completed circuit should have insulation resistance better than $10^9$ ohms, moisture and insulation resistance better than $10^8$ ohms, etc. The circuit should have a peel strength greater than 3 lb/in.-width (at this level of adhesion, the metal is not damaged by applying and removing 3M Scotch™ tape), etc. It should also resist chemical exposure and retain 75% of the measured mechanical properties after exposure to a variety of chemical environments. Furthermore, an electronic circuit should have good thermal stability and be able to pass the solder float test.

The insulating substrate is the support bearing the nuclei for diffusion transfer development and on which the silver image ultimately is adhered. The substrates which can be used in practicing the invention must be electrically insulating and have good moisture resistance. They must also have the necessary mechanical, thermal and chemical stability to allow for later processing steps. The substrate may be either flexible or rigid.

In general, the substrate comprises a polymeric resin which can be in the form of a film or other solid matrix. The resin may be reinforced with stable fibers or inert fillers, cellulosic or polyaramid papers, glass or polyaramid fabrics. Examples of suitable thermoset resins include crosslinkable polymeric acrylics, diallyl phthalates, high performance epoxies, phenolics and silicones. Examples of suitable thermoplastic resins include fluorocarbons, such as polytetrafluoroethylene, polymers of perfluoroalkoxy perfluorovinyl ethers, and copolymers of tetrafluoroethylene and hexafluoropropylene; polyimides such as polyarimides; polyaryl ethers; polyarylketones and polyaryletherketones; polyesters; polyethylene oxides; polyphenylene sulfides; polycarbonates; polyphenylene oxides; polyphenylene sulfides; polysulfones; bismaleimides and bismaleimide triazines; and cyanate esters.

The substrate may also be a laminate of several layers which may be the same or different. For example, epoxy resin reinforced with polyaramid fabrics and laminated to fluoropolymer films can be used.

For applications in which one soldering step will be required, it is necessary to use a substrate with high thermal stability. For these applications polyimides, fluoropolymers and polyesters are preferred flexible substrates and epoxy resin reinforced with glass fabric, FR-4, is a preferred rigid substrate. For applications requiring more than one soldering step, polyimides, fluoropolymers and FR-4 are preferred.

When the substrate is a film, it may be in the form of single sheets or in a continuous roll. For flexible circuit applications, films are used which generally have a thickness in the range of 1 to 5 mils. For rigid circuit applications, thicker materials may also be used. Two and three-dimensional surfaces may be used.

The insulating substrate must be capable of absorbing, adsorbing or otherwise binding the diffusion transfer nuclei without additional binder. In addition the substrate must allow for diffusion transfer development at the nuclei sites and must therefore be swellable in or wettable by the aqueous developer solutions. However, in order to maintain the desired electrical properties it is necessary for the substrate to have good moisture resistance. These seemingly contradictory requirements are met by using the process of the invention wherein the surface of the insulating substrate is treated, either chemically or physically, to make a microscopically thin surface layer more hydrophilic.

Chemical treatments that are useful in practicing the process of the invention generally produce groups on the surface which are polar, often oxygen rich, often binding sites for ions and metals and are hydrophilic, such as hydroxyl, carbonyl, carboxyl, carboxamide groups and the like. The chemically altered surface is more capable of chemically binding the diffusion transfer nuclei or of absorbing the nuclei. In addition, the surface also is swellable in or wettable by the basic aqueous diffusion transfer developer solutions so that diffusion transfer development can take place in depth in the hydrophilized surface layer.

It is important to minimize the depth of the substrate which is affected by the hydrophilizing treatment. This is necessary to minimize the amount of moisture absorbed as moisture can cause blistering in later solder and resolder processing steps, lowers surface resistance and promotes silver and other metal migration. It is preferred that the chemically altered hydrophilic surface layer be from about 0.02 to 0.2 micrometers in thickness.

Physical alterations of the surface that are useful to the process of the invention, generally come from treatments that increase the surface area without weakening significantly the physical strength of the surface as in the case of treatments that leave loose debris. Increased surface area hydrophilizes the surface so that wetting is improved. Increasing the surface area usually improves adhesion of a subsequently added layer by allowing interpenetration of the added layer with the insulating substrate.

Physical hydrophilizing and adhesion promotion has less of an effect on moisture absorption and other critical properties than chemical hydrophilizing and hence it is acceptable to have treatment extend 5 micrometers and more beneath the surface of the insulating substrate for low resolution images. For high resolution and cleaner backgrounds smoother substrates are better and less than 1 micrometer surface roughness preferred.

EP 0 432 493 A2

It is important to avoid leaving loosely attached debris from the hydrophilizing treatment on the surface or leaving a thick layer of extensively degraded substrate on the surface. Usually this is controlled by minimizing the hydrophilizing treatment or removing the loose or weakened material by solvent action and/or mechanical scrubbing during treatment or by separate cleaning steps with solvents and scrubbing.

Hydrophilizing treatments include treatments with strong nonaqueous bases, such as methanolic potassium hydroxide, or with aqueous base solutions; treatment with strong reducing agents, such as sodium metal, lithium amalgam, sodium naphthenate, etc.; treatment with strong oxidizing agents, such as chromate, dichromate or permanganate ions, or milder oxidizing agents, such as sodium persulfate; strong acids, such as concentrated sulfuric; surface roughening or abrading mechanically or by high energy treatment as in argon ion sputtering; and treatment with an electric discharge, corona discharge, reactive plasma, or flame.

It will be recognized that the exact hydrophilizing treatment chosen will depend on the nature of the insulating substrate used. When polyimide film is used as the substrate, the hydrophilizing treatment generally comprises etching with aqueous base solutions including alcohol and or diamines. Suitable etching techniques have been disclosed by De Angelo in U.S. Patent No. 3,821,016; Kreus et al. in U.S. Patent No. 4,426,253; and Knudsen et al. in U.S. Patent No. 4,725,504. Argon ion and other reactive plasma etches also hydrophilize polyimides for metallization processes that give good adhesion.

Fluoropolymer films can be hydrophilized on the surface by treating with strong aprotic bases or with strong reducing agents. Polytetrafluoroethylene surface modification by a variety of methods including flame, plasma, and strong reducing agents is described by L. M. Siperko, R. R. Thomas. J. Adhesion Sci. Technol., 3, 1989, 157-173.

Films such as polyester, polyetherimide, polyarylketones, etc. can be hydrophilized on the surface by treating them with strong oxidizing etchants, strong acid such as concentrated sulfuric, a flame or an electric discharge.

Substrates formed by impregnating epoxy or other resin into reinforcements such as glass, polyaramid fabrics, papers, etc. can be hydrophilized on the surface by roughening and or by chemical etching. Examples of surface roughening techniques include abrasion, sand blasting, solvent crazing, embossing with another rough surface, and certain high energy treatments such as argon ion sputtering, etc. Chemical etching is generally accomplished by treatment with oxidizing agents and acids. For example, an FR-4 substrate can be immersed in permanganate solution to chemically etch and roughen the surface.

When the insulating substrate is a laminate of different materials the surface treatment should be adapted to the material that is on the surface. It will also be recognized that combinations of treatments may be used.

It is also possible to coat the surface of the insulating hydrophobic substrate with another material such as an adhesive layer which is readily hydrophilized on the surface. The coated material must be one which, in addition to having good adhesion to the insulating substrate, has good electrical resistance, chemical resistance, and high temperature stability. The latter property is particularly important for applications with subsequent soldering steps. Although, the adhesive must have some hydrophilicity, i.e., must permit penetration of aqueous silver developer solutions, it must not be too hydrophilic so as to result in excess moisture absorption. Examples of adhesive compositions have been disclosed in U.S. Patent Nos. 3,728,150, 3,822,175, and 3,900,662. These crosslinkable polymeric acrylic adhesive compositions are particularly suitable for polyimide substrates and can be hydrophilized by a brief treatment with aqueous base.

The next step in the process of the invention is the applying of diffusion transfer nuclei to the hydrophilic portion of the insulating substrate. By "diffusion transfer nuclei" is meant particles which act as catalytic sites to aid in the reduction of complexed silver ions to silver metal. Many prior art processes apply the diffusion transfer nuclei as a coating in a binder, typically gelatin, gelatin derivates, cellulose derivatives, dextrin, soluble starch, polyvinyl alcohol, polystyrenesulfonic acid, and copolymers of acrylic acid. These binders are generally not acceptable in electronic applications because they tend to absorb moisture which makes them dimensionally unstable putting stress on the bond between metal and substrate. The absorbed moisture causes blisters and failures in soldering and promotes metal migration and shorts under prolonged use. In order for a binder to be acceptable for electronic applications it must have the high adhesion, to the substrate required of the final circuit, be inert to circuit processing chemicals, be stable to the application of solder, and not degrade electrical performance. It is difficult to develop binders which satisfy all such requirements.

The problem of the selection of an appropriate binder is avoided by the use of the process of the invention. A microscopic surface layer of the insulating substrate is hydrophilized as described above and the diffusion transfer nuclei are applied directly and in the absence of a binder to that hydrophilized surface

5

layer.

Suitable diffusion transfer nuclei for silver diffusion transfer processes are well known in the art. They typically will be (1) a metal, such as silver, gold, palladium, palladium/tin, copper, iron, rhodium and aluminum; (2) sulfides, selenides, tellurides, polysulfides, or polyselenides of metals including silver, zinc, chromium, gallium, iron, cadmium, cobalt, nickel, manganese, lead, antimony, bismuth, arsenic, copper, rhodium, palladium, platinum, lanthanum, and titanium; (3) easily reducible metal salts which form metal nuclei during processing, such as palladium sulfate, silver nitrate or silver citrate; and (4) inorganic salts such as sodium sulfide which react with the incoming diffusing silver salts to form nuclei. Preferred catalysts are copper, silver, palladium/tin, zinc sulfide, palladium sulfide, copper sulfide, nickel sulfide, palladium salts, and palladium sulfate. Of particular interest are sulfides such as zinc sulfide which are excellent nuclei for silver diffusion transfer imaging but do not catalyze electroless nickel and copper plating.

The diffusion transfer nuclei may be applied to the substrate by conventional application procedures such as spraying, sputtering, printing, brushing, dip coating, roll coating, and the like. It is preferred to accomplish this by immersing the treated substrate into an aqueous solution or dispersion of the diffusion transfer nuclei. The concentration of diffusion transfer nuclei on the substrate surface is important to the process of the invention. If too many diffusion transfer nuclei are present this can cause problems in later plating steps, where plating may occur in non-circuit areas. The use of excess diffusion transfer nuclei can also be detrimental to the adhesion and electrical properties of the developed silver image. If too few diffusion transfer nuclei are present, the silver image may not develop adequately and resolution will suffer. It has been found that a level of 0.01 to 30 microgram/$cm^2$ is preferred; 0.5 to 20 microgram $cm^2$ is most preferred.

It has been found that best results are obtained when the development nuclei, usually 0.001 to 0.01 micrometers in diameter, penetrate the hydrophilized layer at least 0.02 micrometers. In some cases, the nuclei penetrate and are dispersed throughout the thickness of the hydrophilized layer. This is observed in electron microscopy of this layer.

Although it is preferred that the steps of hydrophilizing the insulating substrate and applying diffusion transfer nuclei be carried out sequentially, it is possible for the two steps to be carried out simultaneously. For example, if the surface of the insulating substrate is hydrophilized by treating with strong acid, the acidic solution may also contain diffusion transfer nuclei. The diffusion transfer nuclei would deposit on the surface of the substrate as the surface became hydrophilized.

The next step in the process of the invention is the application of the silver halide containing photosensitive layer. This photosensitive layer may be applied directly onto the hydrophobic substrate, after the application of the catalytic nuclei, for a single sheet or diffusion transfer wash out system (DTWO). Alternatively it may be applied to a second support for a two sheet or photomechanical transfer system (PMT).

The hydrophilic surface containing the diffusion transfer development nuclei may be protected with a release layer before contacting with the silver halide photosensitive layer. The release layer prevents contamination of the silver halide layer by mobile diffusion transfer nuclei and minimizes contamination of the insulating substrate surface with colloidal silver formed in the image development in the silver halide layer. The release layer should be permeable to the diffusion transfer developer and removable during rinse steps right after diffusion transfer development. The release layer should be thin to avoid losing image resolution. A thickness of 0.1 to 3.0 micrometers is preferred. Most water swellable, water soluble polymers that are suitable for silver halide photographic coatings are suitable as release layers. Examples include gelatin, phthalated gelatin, cellulose derivatives such as carboxymethylcellulose and hydroxymethylcellulose, and other hydrophilic high molecular weight colloidal substances such as dextrin, soluble starch, polyvinyl alcohol, or polystyrenesulfonic acid.

The silver halide containing photosensitive layer generally comprises a dispersion of silver halide grains in a hydrophilic binder. The binder can be any of the substances commonly used in diffusion transfer processes such as gelatin, phthalated gelatin, cellulose derivatives such as carboxymethylcellulose and hydroxymethylcellulose, and other hydrophilic high molecular weight colloidal substances such as dextrin, soluble starch, polyvinyl alcohol, or polystyrenesulfonic acid. The binder is most conveniently gelatin. The silver halide can be any of the well-known salts used in photographic applications. Representative useful salts include silver chloride, silver bromide, silver iodide, silver chlorobromide, silver iodobromide, and silver chloroiodobromide, either singly or in mixtures. Precipitation of the halide is generally carried out in gelatin using conventional techniques.

The grain size distribution and sensitization of the silver halide can be controlled to adapt the silver halides for the desired photographic process, including laser-imaging, lithographic, direct positive, and the like. The silver halide layer may be either positive-or negative-working. Ordinarily, the silver salt dispersions will be sensitized with conventional compounds such as sulfur, gold, rhodium, selenium and the like, or with organic sensitizing dyes such as cyanine, 1,1'-diethyl-4,4'-cyanine iodide, methine and polymethine cyanine dyes, kryptocyanines, merocyanines, and the like. Other additives commonly employed in silver halide photographic compositions, may also be present if desired.

The amount of silver halide present is generally 5 to 80 $mg/dm^2$ silver with 10 to 15 $mg·dm^2$ preferred for photomechanical transfer from a separate silver halide coated sheet and 10 to 40 $mg·dm^2$, usually 15 $mg/dm^2$ silver, used for single sheet diffusion transfer wash off version. The lowest silver gives the highest resolution images and may need electroless metal plating for good conductivity. The highest silver gives maximum conductivity for direct electroplating of the images.

The next step in the process of the invention is the exposing of at least a portion of the silver halide layer to actinic radiation. This can be accomplished using any of the procedures commonly used with silver halide photographic materials, such as by imaging with UV, visible, or infrared light, a cathode ray tube, or laser. Generally, the silver halide layer is exposed imagewise in the pattern of the desired circuit traces. With negative-working silver halide emulsions, the non-exposed areas of the emulsion will correspond with the developed silver pattern on the insulating substrate.

After exposure, the silver halide layer is contacted with a developer solution and pressed into intimate contact with the diffusion transfer nuclei treated substrate layer. For a one-sheet system this is accomplished by passing the sheet through the developer solution. For a two-sheet system the two sheets are wetted with the developer and then pressed together between rollers with the silver halide layer in contact with the hydrophilised side of the substrate which contains the developer nuclei.

For negative-working silver halide emulsions the silver halide is rapidly reduced to silver metal by the action of the developer in the areas of the emulsion which have been exposed to activating radiation. At the same time, silver ion complexing agents in the developer form soluble silver ion complexes in the unexposed areas. These complexes diffuse to the surface of the insulating substrate. The diffusion transfer nuclei there act as catalytic sites for physical development to deposit metallic silver from the silver ion complexes. In a one-sheet system the top emulsion layer which originally contained the silver halide is then removed, usually by washing. Preferably the emulsion layer is washed off in an acid solution with a pH in the range of 0-5, usually 10% by volume acetic acid. In a two-sheet system the two sheets are peeled apart thus removing the emulsion layer from the substrate. This results in a positive silver image being formed on the insulating substrate layer. When positive-working silver halide emulsions are used, the silver halide in the exposed areas is complexed and diffuses to the substrate layer. This produces a negative image on the insulating substrate layer. Developing baths for the diffusion transfer process are well known in the art and are described, for example, in Photographic Silver Halide Diffusion Processes by Andre Rott and Edith Weyde (Focal Press, 1972) and Modern Photographic Processing, Vol. 2 by Grant Haist (Wiley, 1979).

Following treatment with the developer solution, it is preferred that the system be treated with an acid stop. The acid deswells the hydrophilic surface layer and improves the final electrical resistance of the substrate. Surprisingly, this also improves the adhesion of the developed silver image on the substrate. When the acid stop step is not used, the images may be damaged in rinse steps resulting in permanent loss of adhesion and image components even when substantially aged or plated further. By contrast, when the acid stop is used the diffusion transfer image is tougher and may be scrubbed during rinsing, resists scratching when dry, and its adhesion to the substrate actually may improve with age. This is particularly true with polyimide substrates which were hydrophilized with bases. The acid stop also assists in the removal of the emulsion layer for one-sheet systems. It is preferred that the acid stop be carried out simultaneously with the removal of the layer which originally contained the silver halide (usually gelatin).

The acid stop solution should have a pH less than about 5. A preferred acid stop solution is a 10% by volume aqueous acetic acid solution having a pH of 2.5.

Best results are obtained when the developed silver, like the nuclei, penetrate at least 0.02 micrometers into the hydrophilized surface. This is observed by electron microscopy on this layer. Penetration, which may extend throughout the hydrophilized layer, locks the silver image into the surface and provides good anchorage.

The silver image formed on the substrate is generally very thin. It may be acceptable in some electronic applications such as where low electrical currents are required. However, for most applications it is preferred that the silver image be covered over with additional metal to improve the electrical properties and durability of the circuit image. Examples of metals which can be used to cover or plate over the silver image include, copper, nickel, gold, silver, palladium, zinc, chromium, tin, lead and cobalt and their alloys. It is also possible to cover the image sequentially with different metals. It is preferred to use copper because of its good electrical properties, stability, and economy.

In general, when there are no isolated silver elements in the circuit pattern the silver image will usually be covered by electroplating. Any standard electroplating procedure can be used for this purpose. If the conductivity of the silver image is too low for electroplating and the image has no isolated image elements, then the silver image first is made conductive by electroless plating a small amount of metal and then plated to final full build thickness usually by electroplating.

If there are isolated silver elements in the circuit pattern it is generally preferred to use electroless plating techniques in order to cover the silver image. Examples of metals which can be electrolessly plated include copper, gold, nickel, palladium and cobalt and their alloys. As disclosed in U.S. Patents 3,600,185 and 3,822,127, silver metal must be catalyzed prior to electroless metal plating. Typically, either aqueous palladium chloride or aqueous potassium chloropalladate is used. However, these heavy metal ion solutions may also activate the non-silver areas substrates such as hydrophilized Kapton® polyimide and FR-4 which results in electroless plating over the entire surface. Therefore, it is necessary to selectively activate the silver image and deactivate the background for electroless plating.

It has been found that this selective activation of the silver over the substrate can be accomplished by treating the developed image and substrate with solutions of Pd(II), Pt(IV) or Rh(III) at high halide concentration and relatively low pH, in the range of 3 or less. Suitable halide ions include chloride, bromide and iodide. Chloride is preferred. The halide concentration of the solution is critical to the deactivation of the non-silver areas. Preferably the halide concentration is greater than 0.03 molar and most preferably greater than 1.0 molar. At halide concentration values greater than 0.03 molar, the catalytic activation of the substrate is inhibited without affecting the activation of the silver.

It is felt that the palladium, platinum and rhodium ions deposit on the silver pattern as the reduced metal. This is supported by coupled plasma atomic absorption data showing significant concentrations of the non-silver metal on the pattern after activation. It is felt that the halide ions serve to remove nuclei from the non-silver image areas of the substrate by complexing with the metals of the nuclei promoting oxidation and solubilization. The halide also prevents deposition of the palladium, platinum or rhodium ions on the substrate by complexing with those ions. Other complexing ligands such as thiocyanate, cyanide and phosphite are anticipated to be effective as well in preventing unwanted activation of the substrate.

Silver metal is known to migrate resulting in the formation of dendrite structures. For electronic applications this is totally unacceptable as it can lead to electrical connection between circuit lines and circuit failure. This is one reason that silver metal has not been used to any great extent for circuit patterns. It has been found that dendrite formation can be almost completely eliminated by treating the developed silver patterns with acid, plating with other metals, and treating the plated patterns with a mild etching solution, such as acidic ammonium persulfate. The acid should have a pH of no greater than 2.0. When the silver circuit trace is to be electrolessly plated, the treatment with palladium ions and acid to activate the silver surface for plating discussed above is sufficient so long as the pH is no greater than 2.0. Silver patterns on insulating substrates show typical dendrite formation. Silver patterns which are treated with acid prior to being plated over but are not given a final etch treatment show microscopic dendrite formation after 24 hours under the temperature, humidity, and bias conditions described in ANSI/IPC-FC-241, test method 2.6.3.2, although they do not fail that test. Silver patterns which have been treated with acid, plated over and treated with a final etching solution show no silver migration or dendrite formation under the same conditions when examined under a microscope at 1000X magnification.

It is preferred that after plating the circuit pattern be left in an acidified state. This acid treatment removes surface ions that are deleterious to surface electrical properties. The acid solution should have a pH less than about 5. Preferred acid rinses are 0.1 N sulfuric or hydrochloric acid.

In some cases it may be advantageous to include a baking or aging step in the process of the invention. This is particularly useful when polyimide is used as the insulating substrate. The baking can be accomplished at a temperature of 150° C or below, but temperatures as high as 300° C can be used. The time can be from a few minutes to an hour. Aging generally is accomplished at room temperature for a period of 24 to 72 hours, although longer times can be used. The baking or aging step generally takes place after formation of the silver pattern on the insulating substrate or after the silver image has been covered with at least one conductive metal. The substrate may also be baked after the application of the diffusion transfer nuclei, particularly for substrates coated with crosslinkable polymeric acrylic adhesive materials.

The process of the invention results in the formation of silver images which cannot be removed by rubbing or with Scotch™ tape. It is possible to achieve a resolution of 4 micron lines and grooves and a resistance of less than 10 ohms/square. For some low load applications such as shielding and low voltage/low current circuits the silver image traces can be used without further metallization. It is preferred to protect them with an antiabrasion coating. For more demanding loads and environments such as higher temperatures and humidity, it is preferred to protect them with insulating coatings such as epoxy or silicone resins or to laminate a protective film such as polyimide using an insulating adhesive which greatly reduces silver migration and dendrite formation.

For most applications, the silver traces can be cleanly plated over by metals such as copper by electroplating or electrolessly plating. The plated over traces have good adhesion, in the range of 3 to 8 pli according to ANSI/IPC-FC-241B method 2.4.9; have a moisture and insulation resistance of at least $10^8$ ohms according to ANSI/IPC-FC-241B test method 2.6.3.2; have good chemical resistance and dimensional stability; and do not exhibit silver dendrite formation. Circuits made using substrate films such as polyimide, polyetherimide, polyarylketone, or fluoropolymers and resins reinforced with glass or polyaramid fabrics have sufficient thermal stability to allow for solder and resolder operations. Most preferred are circuits made from polyimide film.

The processes and the articles made by the processes of this invention are primarily used on flat surfaces and may be used for one or both sides of a flat substrate. However, the processes and articles are not limited to flat surfaces. For example, if the hydrophilising and catalytic nuclei treatments are extended to holes in the substrate, the holes can be imaged by silver diffusion transfer and made conductive. For thin substrates both one and two sheet versions give conducting holes. For thick substrates, the one sheet version of the process is preferred.

<u>EXAMPLES</u>

The following examples are illustrative of the invention but are not to be construed as limiting the invention. Unless otherwise indicated, all percentages are by weight. Copies of test procedures can be obtained from the Institute for Interconnecting and Packaging Electronic Circuits, Lincolnwood, Illinois.

<u>Example 1</u>

This example illustrates the preparation of a copper-plated silver circuit using a single-sheet diffusion transfer process according to the invention.

A. Hydrophilic Treatment

A 2 mil thick sample of VN200 Kapton® polyimide film (E. I. du Pont de Nemours & Co., Wilmington, DE) was immersed in an etchant solution consisting of a mixture of 23% by weight 1N KOH and 77% by volume ethanol at 23°C for two minutes. Following this etch, the sample was rinsed and scrubbed with 65°C tap water and air dried.

B. Application of Diffusion Transfer Nuclei

The dried sample from above was treated as follows:
1. immersed in 0.1N NaOH for 1 minute at room temperature followed by a water rinse;
2. immersed in an aqueous acid bath which is 23% Shipley Cataprep 404 (Shipley Corp., Newton, MA) for 1 minute at room temperature;
3. immersed in an aqueous colloidal palladium/tin catalyst (Shipley Cataposit 44, Shipley Corp., Newton, MA) for 2 minutes at 45°C;
4. rinsed for 1 minute in water;
5. immersed in a 10% aqueous solution of fluoroboric acid accelerator (Shipley Accelerator 19, Shipley Corp., Newton, MA) for 3 minutes at 25;
6. rinsed for 1 minute in water;
7. dried in air.

C. Application of Silver Halide

The Kapton® substrate for the above was coated with silver halide photographic emulsion by holding a loop of the film right at the surface of the emulsion solution and moving the film to allow one side to skim the solution surface. The silver halide emulsion was 80% by weight AgCl, 19.5% by weight AgBr and 0.5% by weight AgI. The emulsion was sensitized with standard gold chloride thiosulfate and was also spectrally sensitized to the blue argon/ion laser line. The final coating resulted in 14.9 mg/dm² silver as silver halide

EP 0 432 493 A2

on the substrate as measured by a model 4000 Panalyzer (Panametrics, Waltham, MA). The coating was allowed to air dry.

D. Exposure and Development

The sample from above was masked with a phototool positive of the desired comb test pattern for ANSI/IPC-FC-241B test method 2.6.3.2 and exposed for 9.5 seconds with light of intensity 22 lux from a tungsten source. The exposed sample was immersed for 45 seconds in a solution of 4% sodium sulfate in Universal Developer CP297B (Agfa Gevaert, Teterboro, NJ). The sample was then immediately immersed in an acid stop of 10% by weight aqueous acetic acid. The sample was held in the acid stop for 45 seconds and then the emulsion coating was rubbed off with cotton. The sample was then soaked in DLF fixer (Du Pont Co., Wilmington, DE) for 5 minutes and 0.5 N sulfuric acid for five minutes. The sample was then rinsed in distilled water for 15 minutes and air dried.

The resulting silver comb pattern was electrically conductive. A volt/ohm meter gave a reading of 18 to 100 ohms when the probes were held approximately 1 cm apart on the deposited silver. The amount of transferred silver was 8 mg/dm$^2$. The transmission optical density of the deposited silver as measured on a TR527 Densitometer (Macbeth, Newburgh, NY) was 3.0 to 3.7. The image was not damaged by applying and removing 3M Scotch™ tape.

E. Electroplating with Copper

The sample silver circuit from above was electroplated in an acid copper sulfate plating bath Copper Gleam 125, LeaRonal, Freeport, NY). The bath had the following composition:

| Component | % (Wt. or Vol.) |
|---|---|
| Copper Gleam 125 Carrier | 1.0 (v) |
| Copper Gleam 125 Additive | 0.5 (v) |
| Sulfuric Acid | 10.0 (v) |
| HCl, concentrated | 0.016 (v) |
| $CuSO_4 \cdot 5H_2O$ | 7.5 (w) |
| Carbon Powder (S free) | 0.6 (w) |
| Carbon Granules (S free) | 0.9 (w) |

The sample was plated for 30 minutes at 15 amps per square foot (ASF) and for 45 minutes at 30 ASF to achieve a total copper thickness of 1.4 mils. Using ANSI/IPC-FC-241B test method 2.6.3.2, a moisture and insulation resistance value of at least $2 \times 10^9$ ohms was measured.

Example 2

This example illustrates the preparation of a copper-plated silver circuit using a photomechanical transfer two-sheet process according to the invention.

A. Hydrophilic Treatment

A 2 mil thick sample of VN200 Kapton® polyimide film was surface hydrophilized as described in Example 1.

B. Application of Diffusion Transfer Nuclei

The dried sample from above was treated as follows:
1. immersed in 0.1 N NaOH for 1 minute at room temperature followed by a water rinse;
2. immersed in a 0.02% aqueous solution of $PdSO_4$ for 2 minutes at room temperature followed by a water rinse;
3. immersed in a 10% aqueous solution of $Na_2S \cdot 9H_2O$ for 2 minutes at room temperature;

10

4. rinsed with water and air dried.

C. Application of Silver Halide

Commercially available, photomechanical transfer photographic paper was used for the silver halide sheet-Kodak PMT II Negative Paper, KNP (Eastman Kodak Co., Rochester, NY).

D. Exposure and Development

The sample was to be evaluated using the peel test for which no image is required. Therefore, the emulsion sheet was not exposed to actinic radiation and silver was developed uniformly across the Kapton® substrate.

The unexposed PMT paper was fed along with the Kapton® substrate from step B above into a model 1400 PMT processor (NuArc, Chicago, Illinois) which was charged with Universal Developer CP297B such that the emulsion side of the PMT paper met the hydrophilised surface of the Kapton® substrate shortly after wetting with developer to form a laminate. After 60 seconds, the PMT paper was peeled away from the sample revealing shiny dark silver covering the entire sample surface. The sample was immediately immersed in a 10% aqueous acetic acid stop bath for 60 seconds at 22°C. The sample was then rinsed in 35°C water for 2 minutes and air dried. The silver circuit was electrically conductive. A volt ohm meter gave a reading of 30 ohms when the probes were held approximately 1 cm apart on the deposited silver. As measured by a Panalyzer model 4000, the Kodak PMT paper contains 10.3 mg/dm² silver as silver halide and 6.0 mg/dm² silver or 58% was transferred to the substrate. The image was not damaged by applying and removing 3M Scotch™ tape. The transmission optical density was 2.4.

E. Electroplating with Copper

The sample from step D was electroplated with copper as described in Example 1. The sample had an average 1/8 inch peel strength of 4.5 lb/in.-width according to ANSI/IPC-FC-241B method 2.4.9. After 24 hours of conditioning, the metal/substrate adhesion showed marked improvement, the peel strength increased to 5.9 lb/in-width.

Example 3

This example illustrates electroless plating of the silver circuit patterns of the invention with copper.

The sample silver circuit of Example 1C was activated for 1 minute in a 0.1% palladium sulfate solution in 1 N HCl. The sample was then plated for 5 minutes at 65°C in First Choice™ Electroless Copper plating bath (Callery Chemical Co., Pittsburgh, PA). The final metal thickness was 0.3 to 0.5 micrometers.

Example 4

This example illustrates electroless plating of the silver circuit patterns of the invention with nickel.

The sample silver circuit of Example 1C was activated as described in Example 3. The sample was then plated for 5 minutes at 65°C in Niklad 752 electroless nickel plating bath (Whitco Chemical Corp., New Hudson, MI). The final metal thickness was 0.5 to 0.7 micrometers. The moisture and insulation resistance as measured by ANSI/IPC-FC-241), test method 2.6.3.2, was better than $10^9$ ohms after 24 hours at high temperature and humidity.

Example 5

This example illustrates the preparation of a copper-plated silver circuit according to the invention using an epoxy/glass rigid substrate.

A. Hydrophilic Treatment

A sample of FR-4 glass/epoxy copper laminate (Norplex Oak, La Crosse, WI) was etched with ammoniacal cupric chloride to remove all copper. The copperless sample was treated as follows:

1. immersed in Versa Clean 47 acid cleaner (E. I. du Pont de Nemours & Co., Wilmington, DE) for 1 minute at 54°C;

2. rinsed with water;

3. immersed in an aqueous solution of 13.4% aqueous sodium persulfate and 12.8% sulfuric acid for 1 minute at 25°C followed by a water rinse;

4. immersed in a 10% aqueous sulfuric acid solution for 1 minute followed by a water rinse;

5. immersed in 9267 Conditioner (MacDermid Inc., Waterbury, MA.) for 2 minutes at 46°C followed by a water rinse.

B. Application of Diffusion Transfer Nuclei

The etched sample from above was immersed in MACuPrep 93 Predip (MacDermid Corp., Waterbury, CT) for 3 minutes at 38°C. It was then immersed in MACuPrep 95 activator (MacDermid Corp.) for 3 minutes at 43°C followed by a water rinse. The sample was then immersed in MACuPrep 97 accelerator MacDermid Corp., Waterbury, MA) for 3 minutes at ambient temperature. This was followed by a water rinse and the sample was air dried.

C. Application of Silver Halide

The PMT paper as described in Example 2 was used.

D. Exposure and Development

A sheet of the PMT paper was masked with a phototool positive of the desired circuit and exposed for 6 seconds with light of intensity 1.4 lux from a tungsten source.

The FR-4 substrate from step B was prewet with CP297B Universal Developer and drained for 5 seconds. The exposed PMT paper was taped to a leader film and the leader strung through a tray of CP297B developer around a cylinder immersed 1 to 2 inches in the developer and out up to the nip of a Riston® 2400 laminator (E. I. du Pont de Nemours & Co., Wilmington, DE). The laminator was turned on at the rate of 2.5 meters per minute and the leader drew the exposed PMT film through the developer. As the PMT film reached the nip the FR-4 substrate prewet with developer was inserted in the nip with the PMT film so that the exposed emulsion side of the film was brought in contact with the hydrophilized surface of the FR-4 bearing the diffusion transfer nuclei. After 60 seconds the PMT paper was peeled away from the sample revealing silver traces on the FR-4 surface corresponding to the unexposed regions of the PMT paper. The sample was immediately immersed in a 10% acetic acid stop bath for 60 seconds at 22°C. It was then rinsed with water and air dried.

The silver circuit was electrically conductive. A volt/ohm meter gave a reading of 100 ohms when the probes were held approximately 1 cm apart on the deposited silver. The amount of transferred silver was 7.8 mg/dm$^2$ as measured by a Panalyser Model 4000. The image was not damaged by applying and removing 3M Scotch™ Tape.

E. Electroplating with Copper

The sample was electroplated with copper using the method of Example 1E. The average 1/8 inch peel strength was 6.5 pounds per linear inch according to ANSI/IPC-FC-241B method 2.4.9. The moisture and insulation resistance was at least 10$^8$ ohms as measured by ANSI/IPC-FC-241B test method 2.6.3.2.

<u>Example 6</u>

This example illustrates the use of a continuous roll of polyimide film as the substrate using a single sheet diffusion transfer wash off process according to the invention.

A. Hydrophilic Treatment

A roll of 5 mil thick 14 inch wide Kapton® polyimide film was continuously etched according to the procedure in U.S. Patent 4,725,504, Example 5.

B. Application of Diffusion Transfer Nuclei

The hydrophilized sample from A was treated according to the procedure in Example 1B.

C. Application of Silver Halide

The sample from B was slit to 11 inch width and continuously coated on a bar coater normally used for coating photographic emulsions with a silver halide emulsion in which the silver halide was 80% by weight AgCl, 19.5% by weight AgBr and 0.5% by weight AgI. The emulsion was sensitized with standard gold chloride/thiosulfate and was also spectrally sensitized to HeNe laser imagesetter exposure. The substrate was simultaneously overcoated with a gelatin/matte antiabrasion overcoat. Neither layer contained any hardener. The emulsion layer contained 14.4 mg/dm² silver (as silver halide) as measure on a model 4000 Panalyzer. The antiabrasion overcoat was approximately 2 micrometers thick.

D. Exposure and Development

The coated sample from C was contacted with a multipurpose phototool and exposed for 35 seconds at 1.4 lux with a tungsten lamp.
The exposed sample was developed for 1 minute in a 4% solution of sodium sulfate in Universal Developer CP297B at 26° C. The sample was immediately immersed in a 10% acetic acid solution at 26° C for 1 minute and the emulsion rubbed off with cotton revealing a bright shiny light silvery image that duplicated the original phototool. The imaged sample was then rinsed in tap water at 35° C for 1 minute.
The image contained 6.7 mg/dm² developed silver as measured by a model 4000 Panalyzer. A volt ohm meter measured 7 ohms when probes contacted the developed silver about 1 cm apart. The transmission optical density was 3.0 whereas Kapton® polyimide alone measured 0.59.

Example 7

A silver circuit was prepared as in Example 6 except that the antiabrasion overcoat was not used and a 30 second contact exposure was used. The emulsion layer contained 16.3 mg·dm² silver (as silver halide) after coating and prior to exposure.
The image contained 5.9 mg/dm² shiny silver after development. A volt ohm meter read 7 ohms when probes contacted the developed silver about 1 cm apart. The transmission optical density was 2.7 The resolution was excellent with the 4 micron lines and grooves of the phototool being reproduced.

Example 8

A. Hydrophilic Treatment

A roll of 5 mil thick 14 inch wide Kapton® polyimide film was continuously etched according to the procedure in U.S. Patent 4,725,504, Example 5.

B. Application of Diffusion Transfer Nuclei

The hydrophilized sample from A was treated according to the procedure in Example 1B.

C. Application of Silver Halide

The sample from B was slit to 11 inch width and continuously coated on a bar coater normally used for coating photographic emulsions with a yellow light safe silver halide emulsion in which the silver halide was 100% by weight AgCl, which was chemically sensitized with thiosulfate. The emulsion contained no hardener. The coating contained 14.2 to 17.4 mg/dm² silver (as silver halide) as measured by a model 4000 Panalyzer.

D. Exposure and Development

The coated film from C was contacted with a multipurpose phototool and exposed by a 1000 watt tungsten halogen lamp at 122 cm inches for 30 seconds. The exposed sample was developed as in Example 6D.

The image contained 9.4 mg/dm$^2$ developed silver as measured by a model 4000 Panalyzer. A volt ohm meter measured 5 ohms when probes contacted the developed silver about 1 cm apart. The resolution was excellent with the 4 micron lines and grooves of the phototool being reproduced.

## Example 9

This example illustrates a semi-continuous process where the Kapton® polyimide is automatically etched, catalyzed, coated with emulsion and imaged. Although the sample was developed manually, this step could be automated as well.

The emulsion coated sample from Example 6C was continuously imaged using a HighLight System (E. I. du Pont, Wilmington, DE) with a digitally driven He/Ne laser source. A filter setting of 7.0 and a 7.5 to 15 cm/min feed speed was used. Because of the size of the laser beam, the resolution of this imaging system is limited to 1 mil.

The exposed sample was developed for 1 minute in a 4% solution of sodium sulfate in Universal Developer CP297B at 26°C. The sample was immediately immersed in 10% acetic acid solution at 26°C. for 1 minute and the emulsion rubbed off with coon revealing a bright, shiny, light silvery image that duplicated original digital image. The imaged sample was rinsed in tap water at 35°C for 1 minute.

The image contained 8.4 mg/dm$^2$ developed silver as measured by a model 4000 Panalyzer. A volt ohm meter measured 9 ohms when probes contacted the developed silver about 1 cm apart. The transmission optical density was 3.0 whereas Kapton® polyimide alone measured 0.6.

## Example 10

This example illustrates the necessity of preparing the very thin hydrophilic layer on the substrate prior to silver diffusion transfer to establish good adhesion between the metal and the substrate.

The procedure presented in Example 2 was carried out using a sample of VN2000 Kapton® polyimide film except that step 2A was omitted. The deposited shiny silver circuit was electrically conductive. A volt ohm meter gave a reading of 30 ohms when the probes were held approximately 1 cm apart on the deposited silver. In this case, the image was completely removed by applying and removing 3M Scotch™ Tape. The sample was electroplated as in step 2E. However, the plated metal had essentially no adhesion to the substrate.

A silver image on Kapton® polyimide film prepared as above, where the hydrophilic treatment step 2A was left out, was retested after 247 days and again the tape test fails completely. This shows that aging will not overcome adhesion to non-hydrophilized Kapton®.

## Example 11

This example illustrates the necessity of having high chloride concentration and low pH in the selective activation of silver for electroless plating.

The sample silver circuit of Example 2D was activated for 1 minute in a 0.1% aqueous solution of potassium tetrachloropalladate. After rinsing, the sample was plated with electroless nickel. The plating was not selective and the entire sample was covered with nickel metal. The pH of the activating solution was lowered in stages with hydrochloric acid. At a pH of 1.5, corresponding to a chloride concentration of 0.03 molar, the activation action became selective and only the silver was plated with nickel. Similarly, a 0.1% aqueous solution of palladium sulfate in 0.1 M potassium chloride gave selective activation. The results are summarized in the following Table:

| Activation Selectivity as a Function of pH and Chloride Concentration | | | |
|---|---|---|---|
| Activation Solution | pH | Chloride Concentration (Molar) | Activation for Nickel Plating |
| 0.1% Potassium Tetrachloropalladate | 3.6 | 0.001 | Silver and Kapton® polyimide |
| 0.1% Potassium Tetrachloropalladate plus Hydrochloric Acid | 2.5 | 0.003 | Silver and Kapton® polyimide |
| 0.1% Potassium Tetrachloropalladate plus Hydrochloric Acid | 2.0 | 0.01 | Silver and Kapton® polyimide |
| 0.1% Potassium Tetrachloropalladate plus Hydrochloric Acid | 1.5 | 0.03 | Silver |
| 0.1% Potassium Tetrachloropalladate plus Hydrochloric Acid | 1.0 | 0.1 | Silver |
| 0.1% Palladium Sulfate in 0.1 M Potassium Chloride | 3.0 | 0.1 | Silver |

Example 12

This example illustrates the use of a post-development acid treatment to enhance the wet strength of the silver image during water rinse.

A. Hydrophilic Treatment

A roll of 2 mil Kapton® polyimide film was continuously etched as in Example 6A.

B. Application of Diffusion Transfer Nuclei

The hydrophilized sample from 12A was treated according to the procedure in Example 1B.

C. Application of Silver Halide

The PMT paper described in Example 2C was used.

D. Exposure and Development

A sheet of the PMT paper was masked with a phototool and exposed for 6 seconds with light of intensity 1.4 lux from a tungsten source.

The exposed PMT paper was fed along with a sheet of the Kapton® polyimide substrate from step B. above into a model 1400 PMT processor (NuArc, Chicago, Illinois) which was charged with a solution of 4% sodium sulfate in Universal Developer CP297B (Agfa Gevaert, Teterboro, NJ) such that the emulsion side of the PMT paper met the hydrophilized surface of the Kapton® substrate shortly after wetting with developer to form a laminate. After 60 seconds, the PMT paper was peeled away from the sample revealing a shiny silver image on the surface of the substrate. The sample was then rinsed in 35°C water for 2 minutes. While in the water, an edge was rubbed causing severe damage. The image was air dried.

A second sheet of catalyzed substrate from step B above was imaged and developed in the same manner as in steps C and D above except that in step D. after the PMT paper was peeled from the developed image the imaged substrate was immediately immersed in 10 volume % aqueous acetic acid for 60 seconds at 22°C before rinsing in 35°C water for 2 minutes. While in the water this acid treated sample was rubbed causing no damage under conditions where the non-acid treated sample above was severely damaged. This demonstrates that post-development acid treatment prevents damage during handling in wet processing.

Example 13

This example illustrates machine processing of rigid substrates, high resolution imaging of rough FR-4 fiber glass reinforced epoxy boards, and a developer formulation.

An FR-4 substrate was hydrophilized and treated with diffusion transfer nuclei as described in Example 5A and B above. PMT paper as described in Example 2 was used as the silver photosensitive material.

D. Exposure and Development

1. Equipment

A Richmond Micro III® 18 "straight through" processor (Richmond/Graphic Products, Inc., Providence, RI) was modified to accept variable thickness samples by spring loading the exit rollers to apply 120 ounces of pressure. This processor conveys rigid substrates horizontally through rollers that prewet the catalyzed surface with developer. At exit rollers the substrate meets the exposed and developer-wetted imaged silver halide PMT film to form a laminate for diffusion transfer.

| 2. Developer | |
|---|---|
| Ingredients | % |
| $Na_2SO_3$ Anhydrous | 4.8 |
| Ethylenediaminetetraacetic acid, disodium salt, dihydrate | 0.08 |
| $Na_2S_2O_35H_2O$ | 2.0 |
| KBr | 0.08 |
| Hydroquinone | 0.96 |
| Phenidone | 0.16 |
| Water to make up to 100%<br>KOH to adjust pH to 13.0 | |

3. Exposure and Development

A sheet of PMT paper as described in Example 2C was exposed as in Example 5D and fed emulsion side up into the bottom channel of the modified Micro III® processor (of step D1 above) which was loaded with the developer of step D2 above. Simultaneously, the FR-4 board described above was fed into the top channel of the Micro III® with the active side facing down. The laminate of the PMT paper and board was held for 60 seconds, peeled apart, and the board soaked 60 seconds in 10 volume % aqueous acetic acid, rinsed 60 seconds in 45°C water, and air dried.

The board had a sharp image with a clean background. A volt ohm meter gave a reading of 40 to 60 ohms when the probes were held approximately 1 cm apart on the black silver image. The image was not damaged by applying and removing 3M Scotch® tape. Features as small as 4 micron lines and grooves were partially resolved.

## Example 14

This example illustrates the use of different metal sulfides as diffusion transfer nuclei. The samples were prepared as in Example 2 except that the hydrophilic treatment in Example 6 was used and a variety of metal sulfides were prepared. Some of the treated sample sheets were baked at 130°C for five minutes as indicated below to improve the bond with the polyimide. These samples were electroplated with copper using the procedure described in Example 1E, and after at least 7 days of conditioning were peel tested as in Example 2. The results are listed in the table below:

| Diffusion Transfer Nuclei | | |
|---|---|---|
| Diffusion Transfer Nuclei | Baked | Peel Strength lb/in width |
| Palladium Sulfide | No | 6.4 |
| Cupric Sulfide | Yes | 3.3 |
| Zinc Sulfide | Yes | 8.2 |
| Nickel Sulfide | Yes | 4.2 |

## Example 15

In this example, the chemical action of the solution used to activate the silver pattern for electroless plating is examined.

A sample of bare silver on Kapton® polyimide prepared according to Example 6 was analyzed by inductively coupled plasma (ICP) atomic absorption and found to have 65 micrograms/square centimeter of silver on the surface. This sample was activated using the procedure described in Example 3 concluding with a water rinse. The resulting activated silver image was reacted with 1% sodium borohydride to simulate the reduction which occurs during electroless plating. This film was analyzed by ICP atomic absorption and the deposited metal was found to be 61 micrograms/square centimeter of silver and 19 micrograms square centimeter of palladium. This illustrates how the silver is partially replaced by palladium during the activation process rendering the silver traces active for electroless plating.

A sample of Kapton® film was hydrophilized and treated and with palladium/tin according to Example 6. It was analyzed for Pd using ICP atomic absorption and found to have 4.6 micrograms/square centimeter of palladium. The film was then treated for 1 minute with 1 N HCl. A subsequent analysis showed that the concentration was less than 1 microgram/square centimeter. In addition, transmission electron micrographs (TEM) at 300,000 X magnification showed that the catalyst particles were present before the chloride treatment and absent after treatment. This illustrates how the action of chloride at low pH prevents the catalyzation of the substrate and removes exposed catalysts which may be present.

Example 16

This example illustrates simultaneous diffusion transfer development of conducting silver coatings on both sides on 2 mil Kapton® polyimide film and through 3/8 inch holes prepunched in the film.

A. Hydrophilic treatment

A 2 mil sheet of VN200 Kapton® polyimide film had several 3/8 inch holes punched in it and then was subjected to the treatment of Example 1A.

B. Application of Diffusion Transfer Nuclei

The procedure of Example 1B was followed.

C. Application of Silver Halide

The silver halide emulsion of Example 1C was applied in the same amount to the substrate but simultaneously to both sides and inside the holes by dip coating.

D. Exposure and Development

The unexposed sample was immersed for 45 seconds in Agfa Universal Developer CP297B, then immediately immersed in 10% by volume aqueous acetic acid. The emulsion coating was rubbed off with cotton. Then the substrate was rinsed in water and air dried.

The sheet had shiny conductive silver coatings on both sides. A volt/ohm meter gave a reading of 5 to 10 ohms on one side and 100 ohms on the other side when probes were held approximately 1 cm apart on the deposited silver on one side. To measure conductivity through the holes, individual holes were isolated by cutting around them and removing them from the sheet. Then when the probes of the volt/ohm meter were contacted to opposite sides of the film surrounding the hole the resistance through a single hole could be determined. Resistances through the hole varied from 740 to 500,000 ohms presumably due to coating variations. The overall transmission optical density of the double sided silver coated film was 5.8.

Similar double sided silver halide coated films but without holes were give minimum exposures separately on each side as in Example 1D and developed to give separate conducting images on both sides of the film.

Example 17

This example illustrates silver diffusion transfer imaging onto the surface of cured WA Adhesive (Du Pont Company, Wilmington, DE), a crosslinkable polymeric acrylic adhesive described in U.S. Patent Nos. 3,728,150, 3,822,175 and 3,900,662.

A. Application of WA Adhesive

A sample of 1 mil Kapton® polyimide film (E. I. du Pont de Nemours & Company, Wilmington, DE) was coated to 1 mil with WA Adhesive solution and dried in an oven for 10 minutes at 120° C. The draw down coating technique was used where adhesive solution was spread over the surface of the film using a #35 wire wound rod. After drying, the adhesive was cured in an oven for 20 minutes at 150° C.

A-B Hydrophilization and Application of Diffusion Transfer Nuclei

1. The Kapton®/WA substrate was treated as described in Example 1 section B, steps 1 through 7.
2. The sample was baked for 10 minutes at 125° C. to bond the catalyst to the adhesive.

C. Metallization

A silver image was formed on the Kapton®WA surface and electroplated with copper as described in Example 2, steps C through E. The sample had an average 1 8 inch peel strength of 7.0 lb. in.-width according to ANSI/IPC-FC-241B method 2.4.9.

## Claims

1. A process for the formation of an adherent electrically conductive metal pattern on an insulating substrate which comprises the steps:

(a) applying a hydrophilic treatment to the insulating substrate to impart hydrophilicity to a surface portion of the substrate wherein a thickness of a surface portion of the substrate to which hydrophilicity is imparted is not greater than 0.2 micrometers,

(b) applying diffusion transfer nuclei in the absence of a binder to a hydrophilic portion of the insulating substrate,

(c) applying a silver halide containing photosensitive material either as a layer on the insulating substrate overlying the diffusion transfer nuclei or as a layer on a second substrate,

(d) exposing to actinic radiation a portion of the photosensitive material layer,

(e) applying developer solution to the layer exposed in step (d),

(f) forming a pattern of silver as a coating on the substrate by silver diffusion transfer wherein a surface portion of the layer contacts the diffusion transfer nuclei,

(g) removing the layer that originally contained the silver halide material while leaving the pattern of silver formed in step (f) on the surface of the insulating substrate, and

(h) applying at least one further coating of an electrical conductor to the pattern of silver wherein:

(I) the adhesion of the silver coating with at least one electrical conductor to the insulating substrate is at least 3.0 pounds/inch width as measured by test ANSI-IPC-FC-241B method 2.4.9 and

(II) the insulating substrate and silver coating coated with at least one electrical conductor has a moisture and insulation resistance value of at least $10^8$ ohms as measured by test ANSI IPC-FC-241B test method 2.6.3.2.

2. A process for the formation of adherent electrically conductive circuitry on an insulating substrate which comprises the steps:

(a) applying a hydrophilic treatment to the insulating substrate to impart hydrophilicity to a surface portion of the substrate wherein a thickness of the surface portion of the substrate to which hydrophilic is imparted is not greater than 0.2 micrometers,

(b) applying diffusion transfer nuclei in the absence of a binder to a hydrophilic portion of the insulating substrate,

(c) applying a silver halide containing photosensitive material either as a layer on the insulating substrate overlying the diffusion transfer nuclei or as a layer on a second substrate,

(d) exposing to actinic radiation a portion of the photosensitive material layer,

(e) applying developer solution to the layer exposed in step (d),

(f) forming a pattern of silver as a coating on the substrate by silver diffusion transfer wherein a surface portion of the layer contacts the diffusion transfer nuclei,

(g) removing the layer that originally contained the silver halide material while leaving the pattern of silver formed in step (f) on the surface of the insulating substrate,

(h) treating the developed pattern of silver with an acidic solution having a pH of from about 0 to 5, wherein step (h) is carried out simultaneously with step (g) or immediately after step (g),

(i) treating the silver pattern from step (h) with an aqueous solution containing metal ions selected from the group consisting essentially of Pd(II), Pt(IV), Rh(III) and mixtures thereof, said solution having a pH no greater than 4.0 and also having a halide ion concentration no less than 0.03 M, and

(j) electrolessly plating the treated silver pattern from step (i) with at least one conductive metal, wherein:

19

(I) the adhesion of the silver pattern electrolessly plated with at least one metal to the insulating substrate is at least 3.0 pounds/inch width as measured by test ANSI-IPC-FC-241B method 2.4.9 and
(II) the insulating substrate and silver pattern electrolessly plated with at least one metal has a moisture and insulation resistance value of at least $10^8$ ohms as measured by test ANSI-IPC-FC-241B test method 2.6.3.2.

3. The process of claim 1 wherein at least one of the following occurs:
(1) the pattern of silver which is formed in step (g) is simultaneously treated with an acidic solution having a pH from about 0 to 5 and
(2) the pattern of silver which is found in step (g) is treated with an acidic solution having a pH from about 0 to 5 after step (g) and prior to step (h).

4. The process of claims 1 or 2 wherein steps (a) and (b) are carried out simultaneously.

5. The process of claims 1 or 2 wherein the silver coating has a resistance no greater than 50 ohms/square.

6. The process of claims 1 or 2 wherein the substrate is thermally stable to allow at least one soldering operation.

7. The process of claim 6 wherein the substrate is thermally stable to allow multiple soldering operations.

8. The process of any one of claims 1 to 7 wherein the substrate is selected from the group consisting of polyimide, polyester, and epoxy resin reinforced with glass fabric.

9. The process of claim 8 wherein the substrate is a polyimide film coated with a crosslinkable polymeric acrylic adhesive.

10. The process of claims 1 or 2 wherein the diffusion transfer nuclei applied in step (b) penetrate at least 0.02 micrometers into the hydrophilic portion of the insulating substrate.

11. The process of claim 10 wherein the diffusion transfer nuclei applied in step (b) penetrate completely through the hydrophilic portion of the insulating substrate.

12. The process of claim 2 wherein after application of all of the further electrical conductor coatings an acidic medium is applied to the electrically conductive coating and insulating substrate.

13. The process of claim 2 wherein the halide in step (i) is chloride.

14. Article formed by the process of at least one of claims 1 to 13.